## Europäisches Patentamt
## European Patent Office
## Office européen des brevets

(11) Veröffentlichungsnummer : **0 053 798**
**B1**

(12) **EUROPÄISCHE PATENTSCHRIFT**

(45) Veröffentlichungstag der Patentschrift :
28.08.85

(51) Int. Cl.⁴ : **H 03 K 19/094, H 02 K 5/02, H 03 F 3/30**

(21) Anmeldenummer : 81110096.5

(22) Anmeldetag : 03.12.81

(54) Monolithisch integrierter Puffer-Inverter.

(30) Priorität : 24.11.81 DE 3146485
05.12.80 US 213533

(43) Veröffentlichungstag der Anmeldung :
16.06.82 Patentblatt 82/24

(45) Bekanntmachung des Hinweises auf die Patenterteilung : 28.08.85 Patentblatt 85/35

(84) Benannte Vertragsstaaten :
DE FR GB IT NL

(56) Entgegenhaltungen :
US-A- 3 775 693
US-A- 4 042 839

(73) Patentinhaber : Deutsche ITT Industries GmbH
Hans-Bunte-Strasse 19 Postfach 840
D-7800 Freiburg (DE)
DE
ITT INDUSTRIES INC.
320 Park Avenue
New York, NY 10022 (US)
FR GB IT NL

(72) Erfinder : Pernyeszi, Joseph
43 Mayflower Circle
Fairfield, CT 06430 (US)
Erfinder : Gollinger, Wolfgang, Dipl.Ing
Reinhold-Schneider-Strasse 18A
D-7803 Gundelfingen (DE)

(74) Vertreter : Stutzer, Gerhard, Dr.
Deutsche ITT Industries GmbH Patent- und Lizenzabteilung Hans-Bunte-Strasse 19 Postfach 840
D-7800 Freiburg (DE)

## Beschreibung

Die Erfindung betrifft monolithisch integrierte, mit Enhancement- und Depletion-Isolierschicht-Feldeffekttransistoren (Feldeffekttransistoren vom Anreichungs- und Verarmungstyp) aufgebaute Puffer-Inverter nach dem Oberbegriff des Patentanspruchs 1. Derartige Puffer-Inverter sind in der US-PS 3 775 693 beschrieben. Sie eignen sich für die Integration entweder mit P-Kanal-Transistoren oder mit N-Kanal-Transistoren und haben die Eigenschaft, daß der Ausgang praktisch das Potential der Betriebsspannung annimmt, wenn der Enhancement-Transistor sperrt, so daß nur eine Betriebsspannungsquelle erforderlich ist. Ferner bleibt der Strombetrag während des Sperrvorgangs im Depletion-Transistor konstant, so daß sich ein schnelles Schalten ergibt, was immer erwünscht ist, da der Ausgang des Puffer-Inverters an weitere Schaltungsteile angeschlossen ist, die kapazitätsbehaftet sind, d. h. das absichtlich ein Kondensator vorgesehen ist oder daß die Eingangskapazität der Schaltungsteile oder deren Streukapazität nicht vernachlässigbar sind. Schnelles Schalten bedeutet also, daß der Puffer-Inverter diese Kapazität in vorgegebener Zeit auf- und/oder entladen kann.

Bei einer gegebenen Verlustleistung zeigt die bekannte Schaltung zwar in diesem Sinne günstige Schalteigenschaften, insbesondere bei höheren Betriebsspannungen, sie wird jedoch nicht allen Anforderungen gerecht. Die im Anspruch gekennzeichnete Erfindung löst somit die Aufgabe, einen bezüglich Schaltgeschwindigkeit und-/oder Kapazitätsbelastbarkeit verbesserten Puffer-Inverter anzugeben, bei dem der Depletion-Endtransistor sicher gesperrt wird.

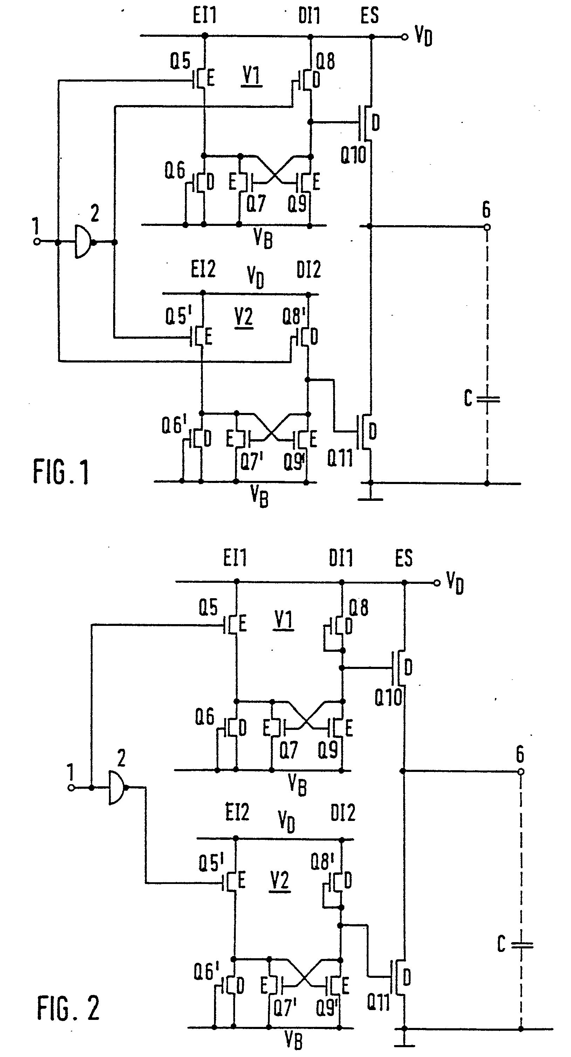

Anhand der Figuren 1 bis 4 der Zeichnung, die Schaltbilder verschiedener Ausführungsformen des Pufferinverters nach der Erfindung gemäß den Patentansprüchen darstellen, wird diese nachstehend näher erläutert. In allen Figuren sind die Enhancement-Transistoren mit E und die Depletion-Transistoren mit O zusätzlich zu den übrigen Bezugszeichen markiert.

In den Fig. 1 bis 3 enthält jede der Ausführungsformen zwei Vorstufen V1, V2, die jeweils aus einem ersten und einem zweiten Enhancement-Load-Inverter EI1, EI2 bzw. ersten und zweiten Depletion-Load-Inverter DI1, DI2 bestehen, die zwischen die Betriebsspannung $V_D$ und die Hilfsspannung $V_B$ von dazu entgegengesetzter Polarität geschaltet sind. Der Betrag der Hilfsspannung $V_B$ ist mindestens jeweils gleich der Gate-Sperrspannung (pinch-off-Spannung) der Depletion-Endtransistoren Q10, Q11; sie beträgt bie N-Kanal-Transistoren somit etwa − 3V. Die Enhancement-Load-Inverter EI1, EI2 bestehen aus den jeweiligen Enhancement-Transistoren Q5, Q5' und den an der Hilfsspannung $V_B$ liegenden Enhancement-Transistoren Q7, Q7'. Diesen sind die Depletion-Transistoren Q6, Q6' parallelgeschaltet, deren Gate und Source mit der Hilfsspannung $V_B$ verbunden sind.

Die beiden Depletion-Load-Inverter DI1, DI2 bestehen jeweils aus den an der Betriebsspannung $V_D$ liegenden Depletion-Transistoren Q8, Q8' und den mit der Source an der Hilfsspannung $V_B$ liegenden Enhancement-Transistoren Q9, Q9'. Die gesteuerten Strompfade der Depletion-Transistoren Q8, Q8' und Enhancement-Transistoren Q9, Q9' sind in Serie geschaltet und ihr gemeinsamer Verbindungspunkt ist ggf. der Puffer-Inverterausgang. Drain und Gate der Enhancement-Transistoren Q7, Q9 bzw. Q7', Q9' sind nach Art eines Flipflops über Kreuz verbunden, das durch den Transistor Q5 bzw. Q5' gesteuert ist. Für die Ausführungsformen nach den Fig. 1 bis 3 gilt darüber hinaus, daß die jeweilige Endstufe ES aus einem an der Betriebsspannung $V_D$ liegenden Depletion-Endtransistor Q10 und einem am Schaltungsnullpunkt liegenden Depletion-Endtransistor Q11 besteht, deren jeweiliges Gate am Ausgang der ersten bzw. des zweiten Depletion-Load-Inverters DI1, DI2 liegt. Die beiden Transistoren Q10, Q11 sind mit ihren gesteuerten Strompfaden in Serie geschaltet, ihr gemeinsamer Verbindungspunkt ist der Ausgang 6 des Puffer-Inverters, and den angeschlossen der gestrichelt gezeichnete Kondensator C als die erwähnte Kapazität gezeigt ist.

Abweichend von diesen Gemeinsamkeiten liegt bei der Ausführungsform nach Fig. 1 der Eingang 1 des Puffer-Inverters direkt an dem Gate des Enhancement-Transistors Q5 des ersten Enhancement-Load-Inverters EI und dem des Depletion-Transistors Q8' des zweiten Depletion-Load-Inverters DI2 sowie über einen Inverter 2 an dem Gate des Enhancement-Transistors Q5' des zweiten Enhancement-Load-Inverters EI2 und dem des Depletion-Transistors Q8 des ersten Depletion-Load-Inverters DI1.

Bei der in Fig. 2 dargestellten Ausführungsform des Puffer-Inverters liegt der Eingang 1 direkt am Gate des Enhancement-Transistors Q5 des ersten Enhancement-Load-Inverters EI1 und über den Inverter 2 am Gate des Enhancement-Transistors Q5' des zweiten Enhancement-Load-Inverters EI2, wobei das Gate des Depletion-Transistors Q8 des ersten Depletion-Load-Inverters DI1 und das Gate des Depletion-Transistors Q8' des zweiten Depletion-Load-Inverters DI2 mit dem Ausgang des betreffenden Depletion-Load-Inverters verbunden ist.

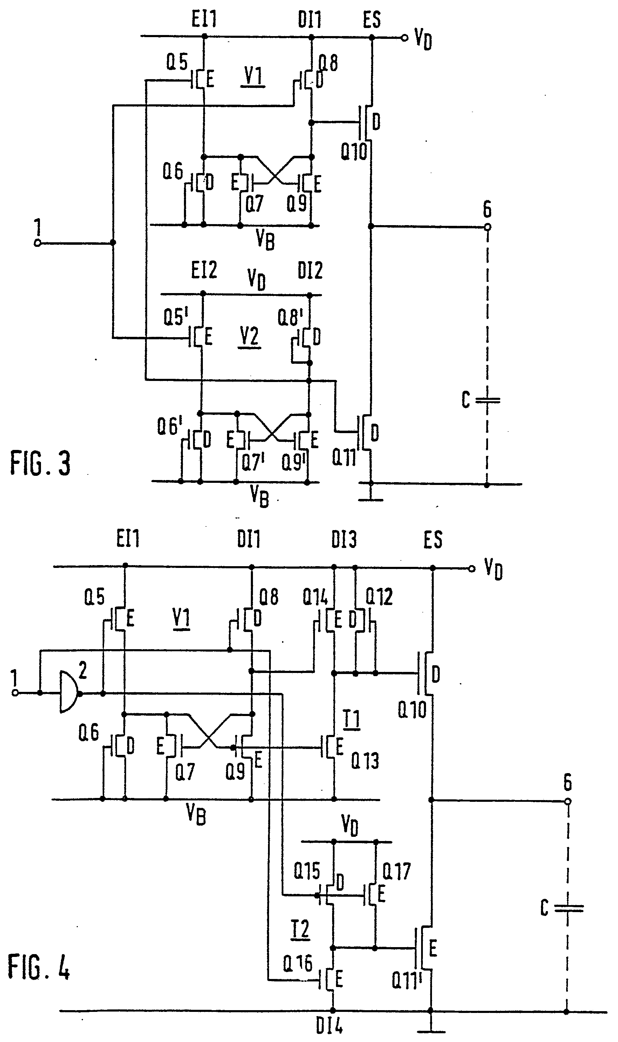

In der Ausführungsform eines Puffer-Inverters nach Fig. 3 liegt der Eingang 1 am Gate des Depletion-Transistors Q8 des ersten Depletion-Load-Inverters DI1 und am Gate des Enhancement-Transistors Q5' des zweiten Enhancement-Load-Inverters EI2; dabei ist das Gate des Enhancement-Transistors Q5 des ersten Enhancement-Load-Inverters EI1 an den Ausgang des zweiten Depletion-Load-Inverters DI2 angeschlossen, an dem auch das Gate seines Depletion-Transistors Q8' liegt. Der Inverter 2 nach Fig. 1 und 2 wird hier nicht benötigt.

Fig. 4 zeigt eine Ausführungsform des Puffer- Inverters die sich nicht nur bezüglich des Einganges sondern auch bezüglich der Endstufe und der Vorstufe V2 von den Ausbildungsformen nach den Fig. 1 bis 3 unterscheidet. So ist in ihr der am Schaltungsnullpunkt liegende Endtransistor der Endstufe ES ein Enhancement-Endtransistor Q11', und die zweite Vorstufe V2 besteht aus einer dem an der Betriebsspannung $V_D$ liegenden Depletion-Endtransistor Q10 zugeordneten ersten Treiberstufe T1 und einer dem Enhancement-Endtransistor Q11' zugeordneten zweiten Treiberstufe T2. Dabei besteht die erste Treiberstufe T1 aus einem zwischen der Betriebsspannung $V_D$ und der Hilfsspannung $V_B$ liegenden dritten Depletion-Load-Inverter DI3, bestehend aus der Serienschaltung des Depletion-Transistors Q12 mit dem Enhancement-Transistor Q13, wobei dem Depletion-Transistor Q12 der mit seinem Gate am Ausgang des ersten Depletion-Load-Inverters DI1 angeschlossene zweite Enhancement-Paralleltransistor Q14 parallelgeschaltet ist. Das Gate des Depletion-Endtransistors Q10 liegt am Ausgang, und das Gate des Enhancement-Transistors Q13 ist mit dem des Enhancement-Transistors Q9 des ersten Depletion-Load-Inverters DI1 verbunden. Die zweite Treiberstufe T2 besteht aus einem zwischen der Betriebsspannung $V_D$ und dem Schaltungsnullpunkt liegenden vierten Depletion-Load-Inverter DI4, dessen Depletion-Transistor Q15 ein dritter Enhancement-Transistor Q17 parallelgeschaltet ist. Der Eingang 1 des Puffer-Inverters nach Fig. 4 ist direkt mit dem Gate des Depletion-Transistors Q8 des ersten Depletion-Load-Inverters DI1 und dem des Enhancement-Transistors Q16 des vierten Depletion-Load-Inverters DI4 verbunden. Über den Inverter 2 ist der Eingang 1 mit dem Gate des Enhancement-Transistors Q5 des ersten Enhancement-Load-Inverters EI1 und dem Gate des Depletion-Transistors Q15 sowie dem des dritten Enhancement-Transistors Q17 des vierten Depletion-Load-Inverters DI4 verbunden.

Zur folgenden Erläuterung der Funktionsweise der in den Figuren 1 bis 4 gezeigten Ausbildungsbeispielen ist vorausgesetzt, daß diese mit positiver Logik arbeiten und aus N-Kanal-Transistoren bestehen, d. h. daß die Betriebsspannung $V_D$ positiv und die Hilfsspannung $V_B$ negativ ist.

Zunächst wird die Funktionsweise des Ausbildungsbeispiels nach Fig. 4 erläutert. Ein am Eingang 1 anliegendes Binärsignal mit den beiden Zuständen H (der positivere der beiden Binärsignalzustände) bzw. L hat im allgemeinen einen Signalsprung zwischen dem Potential des Schaltungsnullpunkts und dem der Betriebsspannung $V_D$. Mittels der Vorstufe V1 wird dieser Signalsprung so verändert, daß er den Bereich zwischen der Hilfsspannung $V_B$ und der Betriebsspannung $V_D$ abdeckt. Dies ist erforderlich, um ein sicheres Sperren des Depletion-Endtransistors Q10 sicherzustellen. Ein am Eingang 1 anliegender H-Pegel steuert den Depletion-Transistor Q8 auf, so daß dieser in seinen Bereich guter Stromführung gelangt. Andererseits wird die Leitfähigkeit des Enhancement-Transistor Q5 durch den über den Inverter 2 in einen L-Pegel verwandelten H-Pegel am Eingang 1 herabgesetzt, so daß Enhancement-Load-Inverter EI in diesem Betriebszustand einen hochohmigen Arbeitswiderstand aufweist. Das kräftige Durchsteuern des Depletion-Transistors Q8 führt dazu, daß an ihm nur eine geringe Spannung abfällt und somit der Ausgang des ersten Depletion-Load-Inverters DI1 praktisch einen H-Pegel führt. Dieser erzeugt am Ausgang des Enhancement-Load-Inverters EI einen L-Pegel, der wiederum den Enhancement-Transistor Q9 gesperrt hält, so daß auch von diesem Transistor aus sich am Ausgang des ersten Depletion-Load-Inverters DI1 etwa ein H-Pegel einstellt. Der Enhancement-Transistor Q5 wirkt als Lastelement des Enhancement-Load-Inverter EI, wenn der Enhancement-Transistor Q7 leitend ist, dagegen wirkt der Enhancement-Load-Inverter EI als Source-Folger mit dem Depletion-Paralleltransistor Q6 als Lastelement, solange der Enhancement-Transistor Q7 gesperrt ist.

Am Ausgang des ersten Depletion-Load-Inverters DI1 tritt somit ein Signalsprung auf, dessen H-Pegel praktisch mit dem des Eingangssignals identisch ist, während dessen L-Pegel, im folgenden mit L' bezeichnet, niedriger als das Potential des Schaltungsnullpunkts liegt. Mit diesem Signalsprung wird der Depletion-Endtransistor Q10 über die Treiberstufe T1 angesteuert. Dadurch wird erreicht, daß dieser Transistor sicher vom L'-Pegel gesperrt wird und sich bezüglich der Endstufe ES somit ein möglichst ideales Gegentaktverhalten ergibt, was mit dem Eingangssignal L-Pegel nicht der Fall wäre.

Mittels der Treiberstufe T1 wird einerseits erreicht, daß der L'-Pegel am Ausgang des ersten Depletion-Load-Inverters DI1 noch näher an das Potential der Hilfsspannung $V_B$ gebracht wird und daß andererseits dieser Inverterausgang besser an die Eingangskapazität des Depletion-Endtransistors Q10 angepaßt ist. Die Steuerung des zweiten Depletion-Load-Inverters DI2 der Treiberstufe T1 erfolgt über das Gate des Enhancement-Transistors Q13, das mit dem Ausgang des Enhancement-Load-Inverters EI1 verbunden ist. Andererseits ist der Enhancement-Transistor Q14 vom Ausgang des ersten Depletion-Load-Inverters DI1 gesteuert, wodurch erreicht wird, daß bei niedrigen Strömen im Depletion-Transistor Q12 die Schaltgeschwindigkeit sich nicht verschlechtert, d. h., wenn der Enhancement-Transistor Q13 durch einen L-Pegel an seinem Gate gesperrt wird und somit im Inverter nur ein geringer Strom fließt, übernimmt der dann durch einen H-Pegel an seinem Gate gerade leitend gesteuerte Enhancement-Transistor Q14 die Aufladung der Gate-Kapazität des Depletion-Endtransistors Q10.

In vergleichbarer Weise ist auch dem Enhancement-Endtransistor Q11' die Treiberstufe T2 zugeordnet, die aus dem dritten Depletion-Load-Inverter DI3 besteht, dessen Depletion-Transistor Q15 der zweite Enhancement-Transistor Q17 parallelgeschaltet ist und der zwischen der Betriebsspannung $V_D$ und dem Schaltungsnullpunkt angeordnet ist. Das Gate des Enhancement-Transistors Q17 ist mit dem des Depletion-Transistors Q15 verbunden und wird vom Eingang 1 über den Inverter 2 angesteuert. Der Enhancement-Transistor Q16 des dritten Depletion-Load-Inverters DI3 wird dagegen direkt vom Eingang 1 aus angesteuert. Somit bewirkt ein H-Pegel am Eingang 1 das Durchsteuern des Enhancement-Transistors Q16 bei gleichzeitigem Sperren des Enhancement-Transistors Q17 und einen Zustand geringer Stromführung im Depletion-Transistor Q15. Dadurch wird am Ausgang des dritten Depletion-Load-Inverters DI3 ein sehr niedriger L-Pegel erzeugt, der den Enhancement-Endtransistor Q11′ sicher sperrt. Bei einem L-Pegel am Eingang des Enhancement-Transistors Q16 dagegen werden die Transistoren Q15, Q17 stark durchgesteuert, so daß am Ausgang des dritten Depletion-Load-Inverters DI3 ein praktisch mit der Betriebsspannung $V_D$ identischer H-Pegel auftritt, der den Enhancement-Endtransistor Q11′ sicher durchsteuert.

In den Ausführungsbeispielen der Figuren 1 bis 3 ist zur Ansteuerung des am Schaltungsnullpunkt liegenden Depletion-Endtransistors Q11 jeweils die zweite Vorstufe V2 vorgesehen, die, wie oben bereits dargelegt wurde, bezüglich der Art, der Anzahl und der Zusammenschaltung der einzelnen Bauelemente mit der ersten Vorstufe V1 identisch ist. Die drei Ausführungsbeispiele nach den Figuren 1 bis 3 unterscheiden sich hinsichtlich der Ansteuerung vom Eingang 1 aus. So dient das Eingangssignal beim Ausführungsbeispiel der Figur 1 in seiner invertierten und seiner nichtinvertierten Form zur Ansteuerung der Last-Transistoren Q5, Q5′ des ersten und des zweiten Enhancement-Load-Inverters EI1, EI2 und der als dynamische Last-Transistoren betriebenen Depletion-Transistoren Q8, Q8′. In der ersten Vorstufe V1 wird der Enhancement-Transistor Q5 vom nichtinvertierten Eingangssignal, der entsprechende Enhancement-Transistor Q5′ in der zweiten Vorstufe V2 dagegen vom invertierten Eingangssignal angesteuert, das auch den Depletion-Transistor Q8 in der Vorstufe V1 ansteuert, während das nichtinvertierte Eingangssignal in der Vorstufe V2 den Depletion-Transistor Q8′ ansteuert.

Während in Fig. 1 somit eine vollständige dynamische Steuerung der Lasttransistoren vorliegt, ist in Fig. 2 im Gegensatz zur Fig. 1 nur vorgesehen, daß die Enhancement-Transistoren Q5, Q5′ in der ersten bzw. zweiten Vorstufe V1, V2 dynamische Lastelemente sind, während die Depletion-Transistoren Q8, Q8′ durch die erwähnte Verbindung ihres Gates mit dem entsprechenden Inverterausgang rein widerstandsgeschaltete Lastelemente sind.

Die Figur 3 zeigt eine weitere Variante, bei der auf den Inverter 2 verzichtet werden kann, weil in der zweiten Vorstufe V2 der Depletion-Transistor Q8′ ein rein widerstandsgeschaltetes Lastelement ist, der Depletion-Transistor Q8′ dagegen ein vom Eingangssignal dynamisch betriebenes Last-element ebenso wie der Enhancement-Transistor Q5′ ist und weil die dynamische Ansteuerung des Enhancement-Transistors Q5 vom Ausgang des zweiten Depletion-Load-Inverters DI2 der zweiten Vorstufe V2 aus erfolgt.

Die Wirkungsweise der beiden Vorstufen V1, V2 in den Ausführungsbeispielen der Figuren 1 bis 3 ist dem Prinzip nach dieselbe wie die der ersten Vorstufe V1 in Fig. 4, wie sie oben bereits beschrieben worden ist. Die zweite Vorstufe V2 liefert wegen ihrer sozusagen inversen Ansteuerung an ihrem Ausgang auch ein zum Ausgangssignal der ersten Vorstufe V1 inverses Ausgangssignal, so daß die Endstufe ES tatsächlich in reinem Gegentakt betrieben wird. Da der am Schaltungsnullpunkt liegende Depletion-Endtransistor Q11 ebenfalls sicher gesperrt werden muß, ist die zweite Vorstufe V2 ebenfalls zwischen der Betriebsspannung $V_D$ und der Hilfsspannung $V_B$ angeordnet, so daß der am Ausgang des zweiten Depletion-Load-Inverters DI2 der zweiten Vorstufe V2 entstehende L′-Pegel auch diesen Transistor Q11 sicher sperren kann.

### Patentansprüche

1. Monolithischintegrierter mit Enhancement- und Depletion-Isolierschicht-Feldeffekttransistoren (E, D) (Feldeffekttransistoren vom Anreicherungs- und Verarmungstyp) aufgebauter Puffer-Inverter mit einer Endstufe (ES) aus zwei mit ihren gesteuerten Strompfaden in Serie zwischen den Schaltungsnullpunkt und eine Betriebsspannung ($V_D$) geschalteten Transistoren (Q10, Q11), von denen der an der Betriebsspannung ($V_D$) liegende ein Depletion-Endtransistor (Q10) ist, gekennzeichnet durch folgende Merkmale :
— eine erste und eine zweite Vorstufe (V1, V2) besteht jeweils aus einem ersten und einem zweiten Enhancement-Load-Inverter (EI1, EI2) bzw. ersten und zweiten Depletion-Load-Inverter (DI1, DI2), die zwischen der Betriebsspannung ($V_D$) und einer Hilfsspannung ($V_B$) von dazu entgegengesetzter Polarität liegen, wobei ein erster Depletion-Transistor (Q6, Q6′) des ersten bzw. des zweiten Enhancement-Load-Inverters (EI1, EI2) an der Hilfsspannung ($V_B$) liegt, mit der auch sein Gate verbunden ist, und der Depletion-Transistor (Q8, Q8′) des ersten bzw. des zweiten Depletion-Load-Inverters (DI1, DI2) an der Betriebsspannung ($V_D$) liegt und dem Enhancement-Transistor (Q7, Q7′) des ersten bzw. zweiten Enhancement-Load-Inverters (EI1, EI2) der jeweils erste Depletion-Transistor (Q6, Q6′) parallelgeschaltet ist und wobei das Gate an der Hilfsspannung ($V_B$) liegenden Enhancement-Transistor (Q7, Q7′) mit der Drain und dessen Drain mit dem Gate des Enhancement-Transistors (Q9, Q9′) des ersten bzw. des zweiten Depletion-Load-Inverters (DI1, DI2) verbunden ist,
— die Endstufe (ES) besteht aus der Reihenschaltung eines an der Betriebsspannung ($V_D$) liegenden Depletion-Endtransistors (Q10) mit einem am Schaltungsnullpunkt liegenden Depletion-Endtransistor (Q11), deren jeweilige Gates am Ausgang des ersten bzw. des zweiten Depletion-Load-Inverters (DI1, DI2), liegen und

— der Eingang (1) liegt

entweder direkt am Gate des Enhancement-Transistor (Q5) des ersten Enhancement-Load-Inverters (EI1) und dem des Depletion-Transistors (Q8') des zweiten Depletion-Load-Inverters (DI2) und über einen Inverter (2) am Gate des Enhancement-Transistors (Q5') des zweiten Enhancement-Load-Inverters (EI2) und dem des Depletion-Transistors (Q8) des ersten Depletion-Load-Inverters (DI1) (Fig. 1)

oder direkt am Gate des Enhancement-Transistors (Q5) des ersten Enhancement-Load-Inverters (EI1) und über den Inventer (2) am Gate des Enhancement-Transistors (Q5') des zweiten Enhancement-Load-Inverters (EI2), wobei das Gate des Depletion-Transistors (Q8) des ersten Depletion-Load-Inverters (DI1) und das Gate des Depletion-Transistors (Q8') des zweiten Depletion-Load-Inverters (DI2) mit dem Ausgang des betreffenden Depletion-Load Inverters verbunden sind (Fig. 2),

oder am Gate des Depletion-Transistors (Q8) des ersten Depletion-Load-Inverters (DI1) und am Gate des Enhancement-Transistors (Q5') des zweiten Enhancement-Load-Inverters (EI2), wobei das Gate des Enhancement-Transistors (Q5) des ersten Enhancement-Load-Inverters (EI1) an den Ausgang des zweiten Depletion-Load-Inverters (DI2) angeschlossen ist, an dem auch das Gate seines Depletion-Transistors (Q8) liegt (Fig. 3).

2. Monolithisch integrierter mit Enhancement- und Depletion-Isolierschicht-Feldeffekttransistoren (E, D) (Feldeffekttransistoren vom Anreicherungs- und Verarmungstyp) aufgebauter Puffer-Inverter mit einer Endstufe (ES) aus zwei mit ihren gesteuerten Strompfaden in Serie zwischen den Schaltungsnullpunkt und eine Betriebsspannung ($V_D$) geschalteten Transistoren (Q10, Q11'), von denen der an der Betriebsspannung ($V_D$) liegende ein Depletion-Endtransistor (Q10) ist, gekennzeichnet durch folgende Merkmale :

— eine erste Vorstufe (V1) besteht aus einem ersten Enhancement-Load-Inverter (EI1) und einem ersten Depletion-Load-Inverter (DI1), die zwischen der Betriebsspannung ($V_D$) und einer Hilfsspannung ($V_B$) liegen, wobei der Depletion-Transistor (Q6) des ersten Enhancement-Load-Inverters (EI1) an der Hilfsspannung liegt, mit der auch sein Gate verbunden ist, und der Depletion-Transistor (Q8) des ersten Depletion-Load-Inverters (DI1) an der Betriebsspannung liegt und dem Enhancement-Transistor (Q7) des ersten Enhancement-Load-Inverters (EI1) der Depletion-Transistor (Q6) parallelgeschaltet ist und wobei das Gate des an der Hilfsspannung ($V_B$) liegenden Enhancement-Transistor (Q7) mit der Drain und dessen Drain mit dem Gate des Enhancement-Transistors (Q9) des ersten Depletion-Load-Inverters (DI1) verbunden ist,

— eine zweite Vorstufe besteht aus einer ersten Treiberstufe (T1) und einer zweiten Treiberstufe (T2),

— die erste Treiberstufe (T1) besteht aus einem zwischen der Betriebsspannung ($V_D$) und der Hilfsspannung ($V_B$) liegenden dritten Depletion-Load-Inverter (DI3), dessen Depletion-Transistor (Q12) ein mit seinem Gate am Ausgang des ersten Depletion-Load-Inverters (DI1) angeschlossener zweiter Enhancement-Transistor (Q14) parallelgeschaltet ist, wobei das Gate des Depletion-Transistors (Q12) am Ausgang liegt und das Gate des Enhancement-Transistors (Q13) mit dem des Enhancement-Transistors (Q9) des ersten Depletion-Load-Inverters (DI1) verbunden ist,

— die zweite Treiberstufe (T2) besteht aus einem zwischen der Betriebsspannung ($V_D$) und dem Schaltungsnullpunkt liegenden vierten Depletion-Load-Inverter (DI4), dessen Depletion-Transistor (Q15) ein dritter Enhancement-Transistors (Q17) parallelgeschaltet ist und der Eingang (1) ist direkt mit dem Gate des Depletion-Transistors (Q8) des ersten Depletion-Load-Inverters (DI1) und dem des Enhancement-Transistors (Q16) des vierten Depletion-Load-Inverters (DI4), dagegen über den Inverter (2) mit dem Gate des Enhancement-Transistors (Q5) des ersten Enhancement-Load-Inverters (EI1) und dem des Depletion-Transistors (Q15) und dem des dritten Enhancement-Transistors (Q17) des vierten Depletion-Load-Inverters (DI4) verbunden,

— die Endstufe (ES) besteht aus der Reihenschaltung eines an der Betriebsspannung ($V_D$) liegenden Depletion-Endtransistors (Q10) mit einem am Schaltungsnullpunkt liegenden Enhancement-Endtransistor (Q11'), deren jeweilige Gates am Ausgang des dritten Depletion-Load-Inverters (DI3) bzw. am Ausgang des vierten Depletion-Load-Inverters (DI4) liegen.

**Claims**

1. Monolithic integrated inverter-buffer using enhancement- and depletion-mode insulated-gate field-effect transistors (E, D) and comprising an output stage (ES) consisting of two transistors (Q10, Q11) having their controlled current paths connected in series between ground and a supply voltage ($V_D$), the transistor (Q10) connected to the supply voltage ($V_D$) being a depletionmode output transistor, characterized by the following features :

— A first prestage (V1) consists of a first enhancement-mode load inverter (EI1) and a first depletion-mode load inverter (DI1), and a second prestage (V2) consists of a second enhancement-mode load inverter (EI2) and a second depletion-mode load inverter (DI2), with the load inverters connected between the supply voltage ($V_D$) and an auxiliary voltage ($V_B$) of opposite polarity, wherein a first depletion-mode transistor (Q6, Q6') in the first and second enhancement-mode load inverters (EI1, EI2) has its source and gate connected to the auxiliary voltage ($V_B$), wherein the depletion-mode transistor (Q8, Q8') in the first and second depletion-mode load inverters (DI1, DI2) is connected to the supply voltage (V_D), wherein the first depletion-mode transistors (Q6, Q6') are connected in parallel with the enhancement-mode transistors (Q7, Q7') in the first and second enhancement-mode load inverters (EI1, EI2), respectively, and wherein the gates of the enhancement-mode transistors (Q7, Q7'), whose sources are coupled to the auxiliary voltage (V_B), are connected to the drains, and their drains to the gates, of the enhancement-mode transistors (Q9, Q9') of the first depletion-mode load inverter (DI1) and the second depletion-mode load inverter (DI2), respectively;

— the output stage (ES) consists of a series combination of the depletion-mode output transistor (Q10), which is connected to the supply voltage (V_D), and a grounded depletion-mode output transistor (Q11), the gates of which are connected to the outputs of the first depletion-mode load inverter (DI1) and the second depletion-mode load inverter (DI2), respectively, and

— the input (1) is connected

either directly to the gate of the enhancement-mode transistor (Q5) of the first enhancement-mode load inverter (E11) and to that of the depletion-mode transistor (Q8') of the second depletion-mode load inverter (DI2), and through an inverter (2) to the gate of the enhancement-mode transistor (Q5') of the second enhancement-mode load inverter (EI2) and to that of the depletion-mode transistor (Q8) of the first depletion-mode load inverter (DI1) (Fig. 1),

or directly to the gate of the enhancement-mode transistor (Q5) of the first enhancement-mode load inverter (EI1) and through the inverter (2) to the gate of the enhancement-mode transistor (Q5') of the second enhancement-mode load inverter (EI2), with the gate of the depletion-mode transistor (Q8) of the first depletion-mode load inverter (DI1) and the gate of the depletion-mode transistor (Q8') of the second depletion-mode load inverter (DI2) connected to the output of the respective depletion-mode load inverter (Fig. 2),

or to the gate of the depletion-mode transistor (Q8) of the first depletion-mode load inverter (DI1) and to the gate of the enhancement-mode transistor (Q5') of the second enhancement-mode load inverter (EI2), with the gate of the enhancement-mode transistor (Q5) of the first enhancement-mode load inverter (EI1) and the gate of the depletion-mode transistor (Q8') of the second depletion-mode load inverter (DI2) coupled to the output of the second depletion-mode load inverter (DI2) (Fig. 3).

2. Monolithic integrated inverter-buffer using enhancement- and depletion-mode insulated-gate field-effect transistors (E, D) and comprising an output stage (ES) consisting of two transistors (Q10, Q11') having their controlled current paths connected in series between ground and a supply voltage (V_D), the transistor (Q10) connected to the supply voltage (V_D) being a depletion-mode output transistor, characterized by the following features :

— a first prestage (V1) consists of a first enhancement-mode load inverter (EI1) and a first depletion-mode load inverter (DI2) which are connected between the supply voltage (V_D) and an auxiliary voltage (V_B), wherein the gate and the source of the depletion-mode transistor (Q6) of the first enhancement-mode load inverter (EI1) are connected to the auxiliary voltage, wherein the drain of the depletion-mode transistor (Q8) of the first depletion-mode load inverter (DI1) is connected to the supply voltage, wherein the depletion-mode transistor (Q6) of the first enhancement-mode load inverter (EI1) is connected in parallel with the enhancement-mode transistor (Q7) of the first enhancement-mode load inverter (EI1), and where in the gate and drain of the enhancement-mode transistor (Q7) of the first enhancement-mode load inverter (DI1), which has its source connected to the auxiliary voltage (V_B), are connected, respectively, to the drain and the gate of the enhancement-mode transistor (Q9) of the first depletion-mode load inverter (DI1) ;

— a second prestage (V2) consists of a first driver stage (T1) and a second driver stage (T2) ;

— the first driver stage (T1) consists of a third depletion-mode load inverter (DI3) connected between the supply voltage (V_D) and the auxiliary voltage (V_B) and having its depletion-mode transistor (Q12) connected in parallel with a second enhancement-mode transistor (Q14) having its gate coupled to the output of the first depletion-mode load inverter (DI1), with the gate of the depletion-mode transistor (Q12) coupled to the output, and the gate of the enhancement-mode transistor (Q13) connected to the gate of the enhancement-mode transistor (Q9) of the first depletion-mode load inverter (DI1) ;

— the second driver stage (T2) consists of a fourth depletion-mode load inverter (DI4) connected between the supply voltage (V_D) and ground and having its depletion-mode transistor (Q15) connected in parallel with a third enhancement-mode transistor (Q17), and the input (1) is connected directly to the gate of the depletion-mode transistor (Q8) of the first depletion-mode load inverter (DI1) and to that of the enhancement-mode transistor (Q16) of the fourth depletion-mode load inverter (DI4), and through an inverter (2) to the gate of the enhancement-mode transistor (Q5) of the first enhancement-mode load inverter (EI1) and to the gates of the depletion-mode transistor (Q15) and the third enhancement-mode transistor (Q17) of the fourth depletion-mode load inverter (DI4), and

— the output stage (ES) consists of the depletion-mode output transistor (Q10) in series with a grounded enhancement-mode output transistor (Q11') which have their gates connected to the outputs of the third depletion-mode load inverter (DI3) and the fourth depletion-mode load inverter (DI4), respectively.

**Revendications**

1. Inverseur tampon intégré monolithique constitué de transistors à effet de champ à grille isolée du type à enrichissement et à déplétion (E, D), comprenant un étage final (ES) composé de deux transistors (Q10, Q11) dont les voies de courant commandées sont montées en série entre le point neutre du circuit et une tension de fonctionnement ($V_D$), le transistor relié à la tension de fonctionnement ($V_D$) étant un transistor final à déplétion (Q10), caractérisé en ce que :

— un premier et un second étage préliminaire (V1, V2) se composent chacun d'un premier et d'un second inverseur de charge à enrichissement (EI1, EI2) et d'un premier et d'un second inverseur de charge à déplétion (DI1, DI2), placé entre la tension de fonctionnement ($V_D$) et une tension auxiliaire ($V_B$) de polarité inverse, de manière qu'un premier transistor à déplétion (Q6, Q6') du premier, ou du second, inverseur de charge à enrichissement (EI1, EI2) est relié à la tension auxiliaire ($V_B$), à laquelle est également raccordée sa grille, le transistor à déplétion (Q8, Q8') du premier, ou du second, inverseur de charge à déplétion (DI1, DI2) étant relié à la tension de fonctionnement ($V_D$) et le premier transistor à déplétion (Q6, Q6') étant monté en parallèle avec un transistor à enrichissement (Q7, Q7') du premier, ou du second, inverseur de charge à enrichissement (EI1, EI2), de manière que la grille du transistor à enrichissement (Q7, Q7') relié à la tension auxiliaire ($V_B$), est raccordée au drain et son drain à la grille du transistor à enrichissement (Q9, Q9') du premier, ou du second, inverseur de charge à déplétion (DI1, DI2) ;

— en ce que l'étage final (ES) est composé d'un montage en série constitué d'un transistor final à déplétion (Q10) relié à la tension de fonctionnement ($V_D$) et d'un transistor final à déplétion (Q11) relié au point neutre du circuit, les grilles desdits transistors étant respectivement raccordées à la sortie du premier et du second inverseur de charge à déplétion (DI1, DI2) ;

— et en ce que l'entrée (1) est reliée :
soit directement à la grille du transistor à enrichissement (Q5) du premier inverseur de charge à enrichissement (EI1) et à celle du transistor à déplétion (Q8') du second inverseur de charge à déplétion (DI2) et, par l'intermédiaire d'un inverseur (2), à la grille du transistor à enrichissement (Q5') du second inverseur de charge à enrichissement (EI2) et à celle du transistor à déplétion (Q8) du premier inverseur de charge à déplétion (DI1) (Fig. 1),
soit directement à la grille du transistor à enrichissement (Q5) du premier inverseur de charge à enrichissement (EI1) et, par l'intermédiaire de l'inverseur (2) à la grille du transistor à enrichissement (Q5') du second inverseur de charge à enrichissement (EI2), la grille du transistor à déplétion (Q8) du premier inverseur de charge à déplétion (DI1) et la grille du transistor à déplétion (Q8') du second inverseur de charge à déplétion (DI2) étant reliées à la sortie de l'inverseur de charge à déplétion correspondant (Fig. 2), ou encore à la grille du transistor à déplétion (Q8) du premier inverseur de charge à déplétion (DI1) et à la grille du transistor à enrichissement (Q5') du second inverseur de charge à enrichissement (EI2), la grille du transistor à enrichissement (Q5) du premier inverseur de charge à enrichissement (EI1) étant reliée à la sortie du second inverseur de charge à déplétion (DI2) à laquelle est également raccordée la grille de son transistor à déplétion (Q8') (Fig. 3).

2. Inverseur tampon intégré monolithique constitué de transistors à effet de champ à grille isolée du type à enrichissement et à déplétion (E, D), comprenant un étage final (ES) composé de deux transistors (Q10, Q11) dont les voies de courant commandées sont montées en série entre le point neutre du circuit et une tension de fonctionnement ($V_D$), le transistor relié à la tension de fonctionnement ($V_D$) étant un transistor final à déplétion (Q10), caractérisé en ce que :

— un premier étage préliminaire (V1) se compose d'un premier inverseur de charge à enrichissement (EI1) et d'un premier inverseur de charge à déplétion (DI1) placés entre la tension de fonctionnement ($V_D$) et une tension auxiliaire ($V_B$), de manière que le transistor à déplétion (Q6) du premier inverseur de charge à enrichissement (EI1) est relié à la tension auxiliaire à laquelle est également raccordée sa grille, le transistor à déplétion (Q8) du premier inverseur de charge à déplétion (DI1) étant relié à la tension de fonctionnement et le transistor à déplétion (Q6) étant monté en parallèle avec un transistor à enrichissement (Q7) du premier inverseur de charge à enrichissement (EI1), de manière que la grille du transistor à enrichissement (Q7), relié à la tension auxiliaire ($V_B$), est reliée au drain et son drain à la grille du transistor à enrichissement (Q9) du premier inverseur de charge à déplétion (DI1) ;

— en ce qu'un second étage préliminaire se compose d'un premier étage excitateur (T1) et d'un second étage excitateur (T2),

— en ce que le premier étage excitateur (T1) se compose d'un troisième inverseur de charge à déplétion (DI3) placé entre la tension de fonctionnement ($V_D$) et la tension auxiliaire ($V_B$), un second transistor à enrichissement (Q14) relié par sa grille à la sortie du premier inverseur de charge à déplétion (DI1) étant monté en parallèle sur le transistor à déplétion (Q12) dudit inverseur de charge à déplétion (DI3), de manière que la grille du transistor à déplétion (Q12) est reliée à la sortie et que la grille du transistor à enrichissement (Q13) est reliée à celle du transistor à enrichissement (Q9) du premier inverseur de charge à déplétion (DI1) ;

— en ce que le second étage excitateur (T2) se compose d'un quatrième inverseur de charge à déplétion (DI4) placé entre la tension de fonctionnement ($V_D$) et le point neutre du circuit, un troisième transistor à enrichissement (Q17) étant monté en parallèle avec le transistor à déplétion (Q15) dudit inverseur de charge à déplétion (DI4), de manière que l'entrée (1) est reliée directement à la grille du transistor à déplétion (Q8) du premier inverseur de charge à déplétion (DI1) et à celle du transistor à enrichissement (Q16) du quatrième inverseur de charge à déplétion (DI4) et, à l'inverse, qu'elle est reliée par l'intermédiaire de l'inverseur (2) à la grille du transistor à enrichissement (Q5) du premier inverseur de charge à enrichissement (EI1), à celle du transistor à déplétion (Q15) et à celle du troisième transistor à enrichissement (Q17) du quatrième inverseur de charge à déplétion (DI4) ;

— et en ce que l'étage final (ES) se compose d'un montage en série constitué d'un transistor final à déplétion (Q10) relié à la tension de fonctionnement ($V_D$) et d'un transistor final à enrichissement (Q11') relié au point neutre du circuit, dont les grilles sont respectivement raccordées à la sortie du troisième inverseur de charge à déplétion (DI3) et à la sortie du quatrième inverseur de charge à déplétion (DI4).

**0 053 798**

FIG. 1

FIG. 2

FIG. 3

FIG. 4